# EUROPÄISCHE PATENTSCHRIFT

(11) **EP 2 988 964 B1**
(45) Veröffentlichungstag und Bekanntmachung des Hinweises auf die Patenterteilung: **05.09.2018**
(21) Anmeldenummer: 14722568.4
(22) Anmeldetag: 17.04.2014
(51) Int. Cl.: B60L 5/20, B60M 5/00, G01R 31/00

(54) **VERSCHLEISSERKENNUNGSSYSTEM UND VERFAHREN ZUR VERSCHLEISSERKENNUNG**
WEAR DETECTION SYSTEM AND A METHOD FOR DETECTING WEAR
SYSTÈME ET PROCÉDÉ DE DÉTECTION D'USURE

(30) Priorität: 22.04.2013 DE 102013207271
(43) Veröffentlichungstag der Anmeldung: 02.03.2016
(73) Patentinhaber: Schunk Bahn- und Industrietechnik GmbH, 35435 Wettenberg (DE)
(72) Erfinder: FLEISCHHAUER, Guntram, 35102 Lohra / Kirchvers (DE); PFEFFER, Daniel, 35325 Mücke (DE)
(74) Vertreter: advotec.
(86) Internationale Anmeldenummer: PCT/EP2014/057870
(87) Internationale Veröffentlichungsnummer: WO 2014/173798

(56) Entgegenhaltungen:
- EP-A1- 1 447 263
- EP-A1- 2 312 269
- AU-A1- 2011 202 572
- DE-A1-102009 006 392
- DE-A1-102010 003 874
- DE-A1-102010 042 027
- JP-A- H08 168 102
- KR-A- 20110 062 733
- US-A1- 2010 260 926

## Beschreibung

Die Erfindung betrifft ein Verschleißerkennungssystem mit den Merkmalen des Oberbegriffs des Anspruch 1 sowie ein Verfahren zur Verschleißüberwachung einer Schleifleiste für eine fahrdrahtgebundene Stromversorgung von Fahrzeugen mit den Merkmalen des Oberbegriffs des Anspruchs 8.

Zur Stromversorgung von schienengebundenen aber auch nicht schienengebundenen Fahrzeugen über einen Fahrdraht, kommen regelmäßig Schleifleisten aus Kohlenstoff zum Einsatz. Materialbedingt sind derartige Schleifleisten immer einem Verschleiß durch Abrieb des Kohlenstoffmaterials unterworfen. Beim Einsatz solcher Schleifleisten, beispielsweise auf Lokomotiven von Zügen, ist es nötig, diese bereits vor dem Erreichen einer endgültigen Verschleißgrenze auszutauschen, um gefährliche Betriebszustände, Defekte oder Pannen zu vermeiden. Zwar ist regelmäßig in Schleifleisten eine Notabschaltungsfunktion integriert, welche ein Absenken der Schleifleiste bei Erreichen eines endgültigen Verschleißgrades, oder bereits vorher bei einer Beschädigung der Schleifleiste, bzw. einem Bruch, bewirkt; nach der Auslösung einer solchen Notabschaltung ist eine weitere Stromversorgung und somit ein weiterer Betrieb des Fahrzeugs jedoch mittels dieser Schleifleiste nicht mehr möglich. Um derartige Situationen zu vermeiden ist es vonnöten, die Schleifleisten turnusmäßig im Hinblick auf ihren Verschleißgrad hin zu inspizieren. Derartige Inspektionen erfolgen regelmäßig durch Personal, wobei dies nur aufwendig durchzuführen ist, da die Schleifleisten auf einem Dach eines Fahrzeugs, wie beispielsweise einer Lokomotive angebracht sind und aufgrund der am Fahrdraht anliegenden Hochspannung besondere Sicherheitsvorkehrungen eingehalten werden müssen, weshalb derartige Inspektionen dann nur in Bahnbetriebswerken durchgeführt werden können. Zur Vermeidung dieser aufwändigen Kontrollen sind teilweise automatisierte Verschleißüberwachungssysteme bekannt, welche ein Erreichen einer Verschleißgrenze signalisieren können.

Aus der DE 10 2009 006 392 A1 ist ein Verschleißerkennungssystem bzw. Verfahren zur Verschleißüberwachung einer Schleifleiste bekannt, bei dem oberhalb einer Oberleitung eine Kamera mit einer Lichtquelle zur Bilderfassung eines Pantographen angeordnet ist. Bei der Kamera kann es sich um eine Infrarotkamera handeln. Darüber hinaus ist eine drahtlose Datenübertragung der Bildaufnahmen vorgesehen, wobei eine Kategorisierung der Bildaufnahmen automatisch oder durch Personal erfolgen kann.

Die EP 1 447 263 A1 beschreibt eine Schleifleiste mit einem mehrschichtigen Aufbau. Unter einer oberen Schicht ist eine Schicht angeordnet, die zur Erkennung eines Verschleißes eine andere Farbe aufweist als die obere Schicht. Die betreffende Schicht kann sog. Füllkörper aus Metall oder Keramik aufweisen, die durch einen Verschleiß der oberen Schicht sichtbar werden. Die KR 20110062733 A betrifft ein Verschleißerkennungssystem einer Schleifleiste, bei der innerhalb der Schleifleiste abschnittsweise fluoreszierendes Material als eine Verschleißanzeigemarkierung angeordnet ist. Das fluoreszierende Material kann in verschiedenen Farben in jeweils unterschiedlichen, abgestuften Höhen innerhalb der Schleifleiste angeordnet sein, so dass anhand der jeweiligen durch Abrasion bzw. Verschleiß der Schleifleiste freigelegten farbigen Verschleißanzeigemarkierung ein Verschleißgrad erkennbar wird.

Der vorliegenden Erfindung liegt daher die Aufgabe zugrunde, ein Verschleißerkennungssystem und ein Verfahren zur Verschleißerkennung vorzuschlagen, welche bzw. welches einen Verschleißgrad automatisiert und zuverlässig stufenlos signalisieren bzw. erfassen kann.

Diese Aufgabe wird durch ein Verschleißerkennungssystem mit den Merkmalen des Anspruchs 1 und ein Verfahren zur Verschleißüberwachung mit den Merkmalen des Anspruchs 8 gelöst.

Die erfindungsgemäße Verschleißerkennungssystem umfasst eine Bildverarbeitungsvorrichtung und eine Schleifleiste für eine fahrdrahtgebundene Stromversorgung von Fahrzeugen, wobei die Schleifleiste zumindest eine Verschleißanzeigemarkierung aufweist, welche derart ausgebildet ist, dass sie mittels einer Bildverarbeitungsvorrichtung erfassbar ist, wobei die Bildverarbeitungsvorrichtung eine Infrarotkamera zur Erfassung der Verschleißanzeigemarkierung ist, wobei die Verschleißanzeigemarkierung derart ausgebildet ist, dass sich das von der Bildverarbeitungsvorrichtung erfassbare Bild der Verschleißanzeigemarkierung bei zunehmendem Verschleiß kontinuierlich verändert.

Die Schleifleiste umfasst ein in der Regel aus Kohlenstoff gebildetes Kontaktelement, welches an einem Fahrdraht anliegen kann und dadurch eine elektrische Verbindung mit diesem herstellen kann. Dieses Kontaktelement ist durch einen Schleifleistenträger gehaltert, welcher wiederum auf einem sogenannten Pantograph angebracht ist, welcher seinerseits auf dem Dach eines Fahrzeugs angebracht ist. Das Kontaktelement weist dabei zumindest eine Verschleißanzeigemarkierung auf, die derart ausgebildet ist, dass sie mittels einer Bildverarbeitungsvorrichtung erfassbar ist. Da eine Erkennung optisch erfolgt, besteht nicht die Gefahr einer Übertragungsstörung wie bei funkbasierten Verschleißerkennungssystemen. Die Verschleißanzeigemarkierung kann bei einer Herstellung der Schleifleiste direkt in diese integriert werden und bedarf keines aufwändigen eigenen Herstellungsprozesses. Somit ist eine erfindungsgemäße Schleifleiste mit einer Verschleißanzeigemarkierung auch deutlich kostengünstiger als die bekannten Systeme herstellbar. Darüber hinaus ist eine derartige Schleifleiste vollständig wartungsfrei und kann nach einer automatisch generierten Meldung über ein Erreichen eines definierten Verschleißgrades ausgetauscht werden.

Bei dem erfindungsgemäßen Verschleißerkennungssystem ist die Schleifleiste mittels einer Bildverarbeitungsvorrichtung erfassbar. Die Bildverarbeitungsvorrichtung ist vorteilhafterweise eine Kamera zur Erfassung einer Verschleißanzeigemarkierung. Es ist möglich eine derartige Kamera zur Erfassung der Verschleißanzeigemarkierungen ortsfest entlang einer Strecke anzubringen welche von Fahrzeugen passiert wird, auf welchen eine Schleifleiste angebracht ist. Durch ein derartiges Verschleißerkennungssystem kann eine kontinuierliche Überwachung des Verschleißgrades der Schleifleisten auf vorbeifahrenden Fahrzeugen sichergestellt werden. Es ist beispielsweise denkbar, dass beim Passieren eines Fahrzeugs mit einer Schleifleiste, welche einen definierten Verschleißgrad erreicht bzw. überschritten hat, eine automatische Meldung durch das Verschleißerkennungssystem generiert wird. Die Kamera des Verschleißerkennungssystems kann dabei besonders vorteilhaft an bereits bestehender Infrastruktur, wie z.B. Brücken, Masten oder Gebäuden angebracht werden. Durch ein derartiges Verschleißerkennungssystem kann eine kontinuierliche und zuverlässige Überwachung von Verschleißgraden von Schleifleisten auf fahrdrahtgebundenen Fahrzeugen sichergestellt werden. Aufwendige Kontrollen durch Betriebspersonal können entfallen, wodurch Ausfallzeiten der Fahrzeuge verringert und Kosten eingespart werden können.

Die Kamera des erfindungsgemäßen Verschleißerkennungssystems ist als eine Infrarotkamera ausgebildet. Ist die Verschleißanzeigemarkierung der Schleifleiste derart ausgebildet, dass zwischen ihr und dem restlichen Material der Schleifleiste ein durch die Infrarotkamera detektierbarer Temperaturunterschied besteht, kann durch ein derart ausgebildetes Verschleißerkennungssystem eine Störungsanfälligkeit der Erkennung reduziert werden. Ein derartiges System ist vor allem resistent gegenüber schlechten Beleuchtungsverhältnissen, Niederschlag oder Nebel. Die Kamera kann beispielsweise auch innerhalb eines Tunnels angebracht werden, wodurch Einflüsse aufgrund der Witterung vermieden werden können.

Beim bestimmungsgemäßen Gebrauch der Schleifleiste nutzt sich diese kontinuierlich ab, da durch den Kontakt mit dem Fahrdraht ein stetiger Abrieb des Kohlenstoffs an einer Oberseite stattfindet. Um einen Grad des Verschleißes bzw. des Abriebs der Schleifleiste ermitteln zu können, können eine oder mehrere Verschleißanzeigemarkierungen in die Schleifleiste integriert sein. Sind mehrere gleichartige Verschleißanzeigemarkierungen in die Schleifleiste integriert, so erhöht sich die Zuverlässigkeit der Erkennung, da die Verschleißanzeigemarkierungen redundant zueinander ausgebildet sein können. Befindet sich beispielsweise beim Passieren der Schleifleiste einer Bildverarbeitungsvorrichtung ein optisches Hindernis derart zwischen der Verschleißanzeigemarkierung und der Bildverarbeitungsvorrichtung, dass die Verschleißanzeigemarkierung nicht von der Bildverarbeitungsvorrichtung erfasst werden kann, so kann durch ein Vorhandensein einer weiteren, redundanten Verschleißanzeigemarkierung in der Schleifleiste eine Erkennung eines Verschleißgrades der Schleifleiste dennoch sichergestellt werden. So ist es denkbar eine Vielzahl zueinander redundanter Verschleißanzeigemarkierungen in der Schleifleiste vorzusehen. Anhand dieser Verschleißanzeigemarkierungen kann ein Verschleißgrad der Schleifleiste zuverlässig festgestellt werden und somit können aufwändige Kontrollen durch das Betriebspersonal entfallen.

Die geometrische Form der Verschleißanzeigemarkierung kann dabei nahezu beliebig gewählt werden. Sie kann rund, eckig, kantig oder eine Kombination davon sein. Beispielsweise kann die Verschleißanzeigemarkierung in Form eines Quaders, eines Keils, einer Pyramide, eines Zylinders, eines Kegels, eines Polyeders oder einer Kombination dieser Formen ausgebildet sein. Sind mehrere Verschleißanzeigemarkierungen in der Schleifleiste vorgesehen, so können diese unterschiedlich ausgebildet sein. Durch eine solche Ausbildung einer Verschleißanzeigemarkierung kann eine störungsfreie und zuverlässige Erkennung eines Verschleißgrades der Schleifleiste sichergestellt werden.

Eine Erkennung kann erfolgen, indem sich bei zunehmender Abnutzung der Schleifleiste und schließlich bei Erreichen eines definierten Verschleißgrades ein von der Bildverarbeitungsvorrichtung erfassbares Bild der Schleifleiste gegenüber einem Bild der Schleifleiste vor Überschreitung des definierten Verschleißgrades verändert. Dadurch ist es besonders einfach, das Erreichen eines definierten Verschleißgrades erkennen zu können.

Um einen derartigen Effekt zu bewirken, kann die Verschleißanzeigemarkierung in ein Material der Schleifleiste eingebettet sein, was eine vereinfachte Herstellung und Handhabung der Schleifleiste ermöglicht, da keine weiteren Bauteile an der Schleifleiste angebracht oder verkabelt werden müssen.

In einer besonders vorteilhaften Ausführungsform der Schleifleiste ist die Verschleißanzeigemarkierung aus einem zum Material der Schleifleiste optisch kontrastierenden Material ausgebildet, wodurch sie von der Bildverarbeitungsvorrichtung besonders gut erfassbar ist. Der optisch erfassbare Kontrast kann dadurch hergestellt werden, dass die Verschleißanzeigemarkierung sich vom Material der Schleifleiste hinsichtlich ihrer Farbe, ihrer Reflektionseigenschaften, ihrer oberflächlichen Rauhigkeit oder ihrer thermodynamischen Eigenschaften, wie z.B. der Wärmekapazität, unterscheidet. Sie kann beispielsweise aus einem farblich abgesetzten Kohlenstoff bzw. Grafit ausgebildet sein, was die Ausgestaltung der Schleifleiste auf ein einziges Material reduzieren kann und wodurch ein völlig gleichmäßiger Abrieb der Schleifleiste und der Verschleißanzeigemarkierung sichergestellt werden kann. Um hohen Temperaturen zuverlässig widerstehen zu können, kann die Verschleißanzeigemarkierung darüber hinaus auch aus einem Metall wie z.B. Aluminium, (Edel)stahl, Kupfer oder einer beliebigen an die jeweiligen Bedingungen angepassten Legierung ausgebildet sein. Die Verschleißanzeigemarkierung kann aber auch aus einem sonstigen geeigneten Werkstoff ausgebildet sein.

Die Verschleißanzeigemarkierung kann darüber hinaus auch aus einem Kunststoff, wie beispielsweise Polytetrafluorethylen ausgebildet sein; was die Möglichkeit der Farbgestaltung und damit die Erfassbarkeit der Verschleißanzeigemarkierung deutlich verbessern kann.

Erfindungsgemäß ist die Verschleißanzeigemarkierung derart ausgebildet, dass sich ein Bild ihres Längsschnitts entlang einer senkrechten, bzw. orthogonal zum Fahrdraht stehenden, gedachten Achse, verändert. Dadurch wird es möglich, dass sich das von der Bildverarbeitungsvorrichtung erfassbare Bild der Verschleißanzeigemarkierung bei zunehmendem Abrieb des Schleifleistenmaterials kontinuierlich verändert. Beispielsweise kann die Verschleißanzeigemarkierung derart keilförmig ausgebildet sein, sodass sich das Bild ihres Querschnitts infolge zunehmenden Abriebs der Schleifleiste kontinuierlich vergrößert oder verkleinert. Anhand dieses sich kontinuierlich verändernden Bildes der Verschleißanzeigemarkierung sind nicht nur zwei Verschleißzustände, sondern eine stufenlose Verschleißanzeige zu erhalten.

Darüber hinaus kann die Schleifleiste derart ausgebildet sein, dass die Verschleißanzeigemarkierung in einem einer Fahrtrichtung zugewandten oder einem der Fahrtrichtung abgewandten Randbereich der Schleifleiste derart angeordnet ist, dass eventuelle Beschädigungen oder Abbrüche eines Materials der Schleifleiste in diesem Randbereich mittels der Bildverarbeitungsvorrichtung erfassbar sind. Dadurch können Beschädigungen der Schleifleiste, welche während dem Betrieb entstanden sind, detektiert und gemeldet werden, woraufhin eine genauere Überprüfung des Zustands der Schleifleiste durch Betriebspersonal vorgenommen werden kann. Die Verschleißanzeigemarkierung kann dabei in einem oberen Bereich innerhalb der Schleifleiste derart angeordnet sein, dass am Anfang der Standzeit der Schleifleiste die Verschleißanzeigemarkierung zunächst sichtbar ist und bei Erreichen einer Verschleißgrenze der Schleifleiste das von der Bildverarbeitungsvorrichtung erfassbare Bild der Schleifleiste dahingehend verändert, dass die Verschleißanzeigemarkierung nicht mehr detektiert werden kann. Tritt vor Erreichen dieses Verschleißgrades der Schleifleiste eine Beschädigung der Schleifleiste in einem Bereich der Verschleißanzeigemarkierung auf, wobei die Verschleißanzeigemarkierung ebenfalls beschädigt oder vollständig abgerissen, bzw. abgelöst wird, so kann dies durch die Bildverarbeitungsvorrichtung ebenfalls erfasst werden. Die Verschleißanzeigemarkierung kann jedoch auch in einem unteren Bereich innerhalb der Schleifleiste derart angeordnet sein, dass sie erst bei Erreichen eines definierten Verschleißgrades derart freigelegt wird, dass sie von der Bildverarbeitungsvorrichtung detektiert werden kann. Tritt vor Erreichen dieses Verschleißgrades der Schleifleiste eine Beschädigung der Schleifleiste in einem Bereich zwischen der Verschleißanzeigemarkierung und dem Fahrdraht auf, kann die Verschleißanzeigemarkierung freigelegt sein, wodurch eine Beschädigung der Schleifleiste von der Bildverarbeitungsvorrichtung detektiert werden kann.

Bei dem erfindungsgemäßen Verfahren zur Verschleißüberwachung einer Schleifleiste für eine fahrdrahtgebundene Stromversorgung von Fahrzeugen mit einem Verschleißerkennungssystem, weist das Verschleißerkennungssystem eine Bildverarbeitungsvorrichtung und eine Schleifleiste auf, wobei die Schleifleiste eine Verschleißanzeigemarkierung aufweißt, wobei die Verschleißanzeigemarkierung mittels der Bildverarbeitungsvorrichtung erfasst wird, wobei die Bildverarbeitungsvorrichtung eine Infrarotkamera ist mittels der die Verschleißanzeigemarkierung erfasst wird, wobei die Verschleißanzeigemarkierung derart ausgebildet ist, dass das von der Bildverarbeitungsvorrichtung erfassbare Bild der Verschleißanzeigemarkierung bei zunehmendem Verschleiß kontinuierlich verändert wird. Die Vorteile des Verfahrens zur Verschleißüberwachung betreffend wird auf die nähere Beschreibung der erfindungsgemäßen Schleifleiste und des erfindungsgemäßen Verschleißerkennungssystems verwiesen.

Das Verfahren kann besonders vorteilhaft ausgeführt werden, wenn bei einem Verschleiß der Schleifleiste zumindest eine in die Schleifleiste integrierte Verschleißanzeigemarkierung und damit ein Bild oder eine Gestalt der Schleifleiste verändert wird, und diese Veränderung durch eine Bildverarbeitungsvorrichtung erfasst und ausgewertet wird, und dass dadurch ein Verschleißgrad der Schleifleiste bestimmt wird.

Weitere vorteilhafte Ausführungsformen des Verfahrens ergeben sich aus den Merkmalsbeschreibungen der auf den Vorrichtungsanspruch 1 rückbezogenen Unteransprüche.

Im Folgenden wird die Erfindung unter Bezugnahme auf die beigefügte Zeichnung näher erläutert.

Es zeigen:
- **Fig. 1**: Eine Schnittansicht einer von der Erfindung abweichenden ersten Ausführungsform einer Schleifleiste entlang einer Achse I - I aus Fig. 2;
- **Fig. 2**: eine Schnittansicht der Schleifleiste entlang einer Achse II - II aus Fig. 1;
- **Fig. 3**: eine Schnittansicht der Schleifleiste entlang einer Achse III - III aus Fig. 1;
- **Fig. 4**: eine räumliche Darstellung der Schleifleiste;
- **Fig. 5**: eine Längsschnittansicht einer von der Erfindung abweichenden zweiten Ausführungsform einer Schleifleiste;
- **Fig. 6**: eine Längsschnittansicht einer von der Erfindung abweichenden dritten Ausführungsform einer Schleifleiste;
- **Fig. 7**: eine Längsschnittansicht einer vierten Ausführungsform einer Schleifleiste;
- **Fig. 8**: eine Längsschnittansicht einer von der Erfindung abweichenden fünften Ausführungsform einer Schleifleiste;
- **Fig. 9a**: eine Längsschnittansicht einer von der Erfindung abweichenden sechsten Ausführungsform einer Schleifleiste im unbenutzten Neuzustand;
- **Fig. 9b**: eine Längsschnittansicht der Schleifleiste aus Fig. 9a in einem benutzten Zustand bei Erreichen eines definierten Verschleißgrades;
- **Fig. 10**: eine Längsschnittansicht einer von der Erfindung abweichenden siebten Ausführungsform einer Schleifleiste;
- **Fig. 11**: eine perspektivische Ansicht eines Pantographen mit einer von der Erfindung abweichenden achten Ausführungsform einer Schleifleiste;
- **Fig. 12**: eine Querschnittansicht einer von der Erfindung abweichenden neunten Ausführungsform einer Schleifleiste.

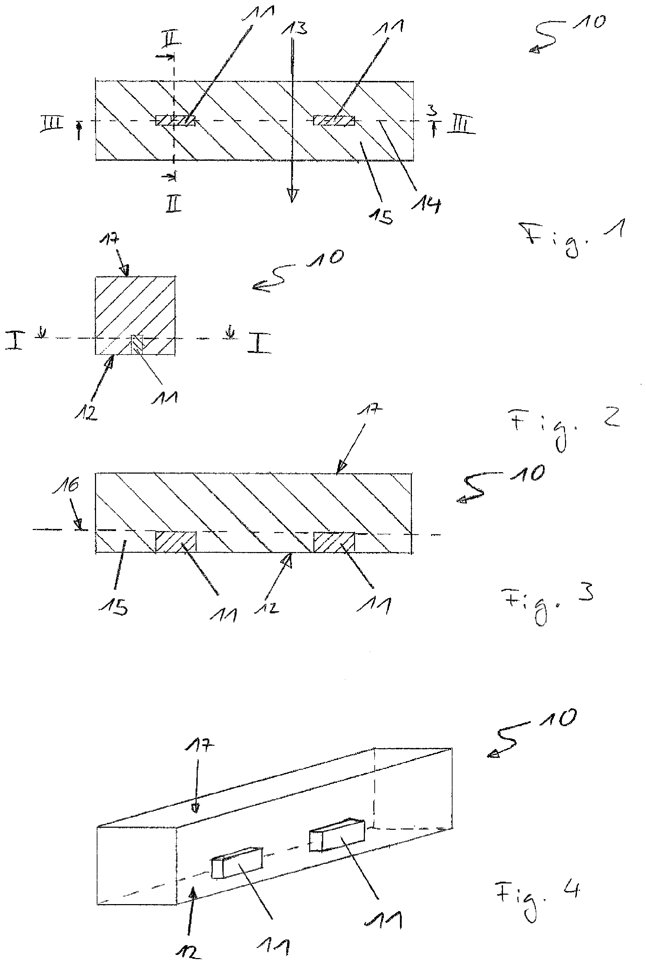

Eine Zusammenschau der **Fig. 1** bis **4** zeigt eine erste Ausführungsform einer Schleifleiste 10 mit zwei Verschleißanzeigemarkierungen 11 in einer schematischen Darstellung, welche innerhalb der Schleifleiste 10, angrenzend an eine einem hier nicht dargestellten dem Fahrdraht abgewandten Unterseite 12 der Schleifleiste, in einer Fahrtrichtung 13 mittig der Schleifleiste 10 gleichmäßig und symmetrisch entlang einer Längsachse 14 angeordnet sind.

Die **Fig. 4** zeigt eine räumliche Ansicht der Schleifleiste 10. Die Schleifleiste 10 ist dabei derart ausgebildet, dass die Verschleißanzeigemarkierungen 11 derart in ein Schleifleistenmaterial 15 der Schleifleiste 10 eingebettet sind, dass sie zunächst für eine hier nicht dargestellte Bildverarbeitungsvorrichtung unerfassbar sind. Bei Erreichen eines durch eine Verschleißgrenze 16 definierten Verschleißgrades infolge eines bestimmungsgemäßen Gebrauchs der Schleifleiste 10 und eines damit einhergehenden Abriebs des Schleifleistenmaterials 15 werden die Verschleißanzeigemarkierungen 11 gegen Ende einer Standzeit der Schleifleiste 10 freigelegt, wodurch ein von der Bildverarbeitungsvorrichtung erfassbares Bild einer Oberseite 17 der Schleifleiste 10 gegenüber einem Bild der Oberseite 17 der Schleifleiste 10 vor Überschreitung des definierten Verschleißgrades verändert ist. Da die Verschleißanzeigemarkierung 11 nach Überschreiten des definierten Verschleißgrades der Schleifleiste 10 einen optischen Kontrast zum restlichen Material 15 der Schleifleiste 10 bildet, kann der Verschleißgrad von der Bildverarbeitungsvorrichtung ermittelt werden, wodurch von der Bildverarbeitungsvorrichtung, bzw. einem mit der Bildverarbeitungsvorrichtung verbundenen, hier ebenfalls nicht dargestellten Computer, eine Meldung über das Erreichen des Verschleißgrades der Schleifleiste 10 generiert werden kann.

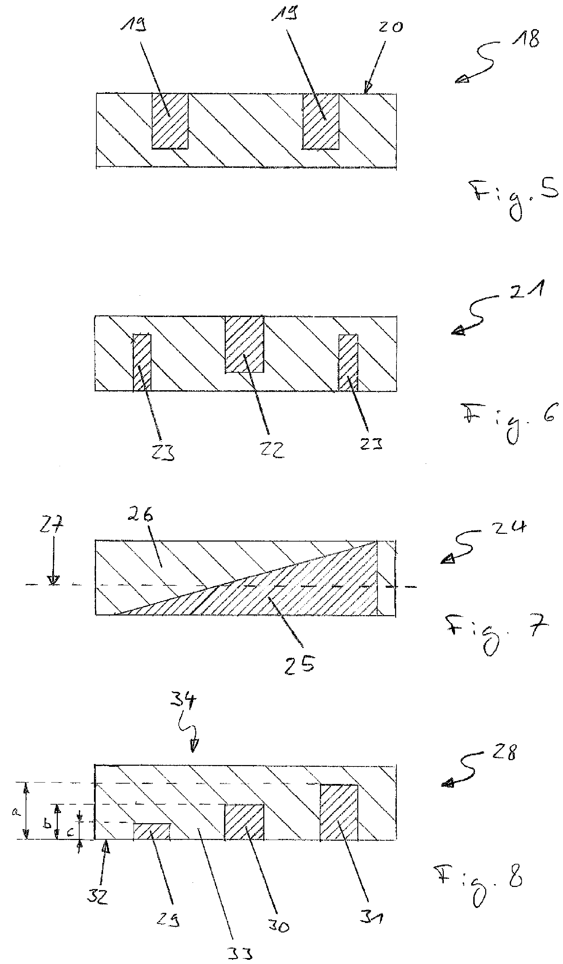

**Fig. 5** zeigt eine weitere Ausführungsform einer Schleifleiste 18 mit Verschleißanzeigemarkierungen 19, welche an einer Oberseite 20 der Schleifleiste 18 innerhalb dieser angeordnet sind. Die Schleifleiste 18 ist derart ausgebildet, dass zu Beginn ihrer Lebensdauer die Verschleißanzeigemarkierungen 19 bereits von einer hier nicht dargestellten Bildverarbeitungsvorrichtung erfasst werden können, wobei bei Erreichen eines definierten Verschleißgrades die Verschleißanzeigemarkierung 19 vollständig konsumiert ist, wodurch sich ein von der Bildverarbeitungsvorrichtung erfassbares Bild der Schleifleiste 18 verändert, was ebenfalls ein Überschreiten eines definierten Verschleißgrades anzeigt.

**Fig. 6** zeigt eine dritte Ausführungsform einer Schleifleiste 21, wobei Verschleißanzeigemarkierungen 22 und 23 derart ausgebildet sind, dass zu Beginn einer Lebensdauer der Schleifleiste 21 ein Teil der Verschleißanzeigemarkierung 22 bzw. ein Bild der Verschleißanzeigemarkierung von einer nicht gezeigten Bildverarbeitungsvorrichtung erfassbar ist, und infolge zunehmenden Abriebs der Schleifleiste 21 die Verschleißanzeigemarkierung 23 bei Erreichen eines ersten definierten Verschleißgrades zutage treten und so von der Bildverarbeitungsvorrichtung erfassbar sind. Bei Erreichen eines weiteren definierten Verschleißgrades der Schleifleiste 21 ist die bereits zu Beginn der Lebensdauer der Schleifleiste 14 erfassbare Verschleißanzeigemarkierung 22 vollständig konsumiert, wodurch dieser von der Bildverarbeitungsvorrichtung nicht mehr erfasst werden kann, wodurch ein weiterer definierter Verschleißgrad der Schleifleiste 21 angezeigt ist.

**Fig. 7** zeigt eine vierte Ausführungsform einer Schleifleiste 24 mit einer keilförmigen Verschleißanzeigemarkierung 25, wobei die Verschleißanzeigemarkierung 25 derart ausgebildet ist, dass zu Beginn einer Lebensdauer der Schleifleiste lediglich ein sehr kleiner Abschnitt bzw. kein Abschnitt der Verschleißanzeigemarkierung 25 von einer hier nicht dargestellten Bildverarbeitungsvorrichtung erfasst werden kann, wobei bei zunehmenden Verschleiß der Schleifleiste 24 infolge Abriebs eines Schleifleistenmaterials 26 aufgrund einer Keilform der Verschleißanzeigemarkierung 25 ein von der Bildverarbeitungsvorrichtung erfassbares Bild der Schleifleiste 24 sich kontinuierlich dahingehend verändert, dass eine von der Bildverarbeitungsvorrichtung erfassbare Längsschnittsfläche 27 der Verschleißanzeigemarkierung 25 stetig zunimmt. Somit kann anhand einer durch die Bildverarbeitungsvorrichtung erfassten Flächengröße oder sichtbaren Länge der Verschleißanzeigemarkierung 25 ein Verschleißgrad der Schleifleiste 24 stufenlos ermittelt werden.

**Fig. 8** zeigt eine fünfte Ausführungsform einer Schleifleiste 28 mit Verschleißanzeigemarkierungen 29, 30, 31, welche ausgehend von einer Unterseite 32 innerhalb der Schleifleiste 28 angeordnet sind und unterschiedliche Höhen a, b, c aufweisen, wobei infolge zunehmenden Abriebs eines Schleifleistenmaterials 33 zunächst bei Erreichen eines ersten definierten Verschleißgrades der Schleifleiste 28 die Verschleißanzeigemarkierung 31 an einer Oberseite 34 der Schleifleiste 28 hervortritt und von einer Bildverarbeitungsvorrichtung erfassbar ist, wobei bei Erreichen eines zweiten definierten Verschleißgrades die Verschleißanzeigemarkierung 30 hervortritt und von der Bildverarbeitungsvorrichtung erfassbar ist, und wobei bei Erreichen eines dritten Verschleißgrades der Schleifleiste 28 die Verschleißanzeigemarkierung 29 ein Bild der Oberseite 34 der Schleifleiste 28 dahingehend verändert, dass das Erreichen eines weiteren definierten Verschleißgrades der Schleifleiste 28 angezeigt ist.

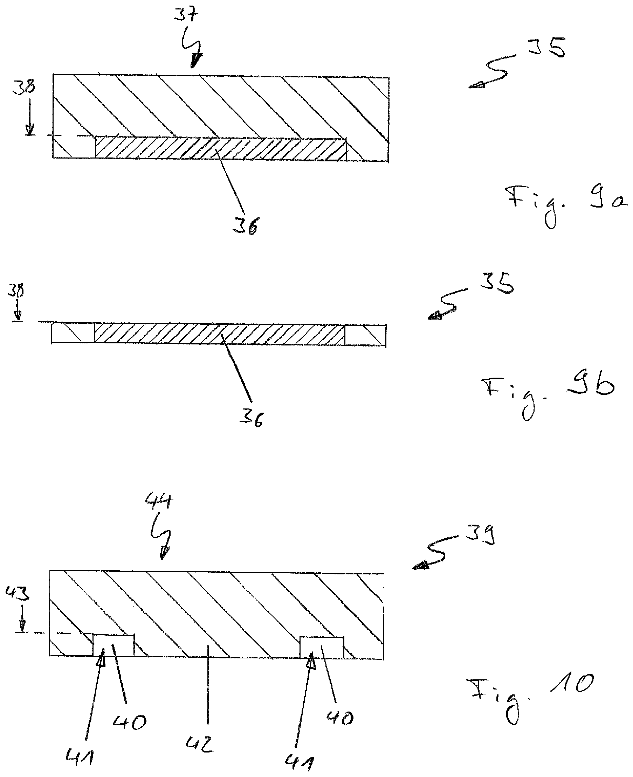

**Fig. 9a** zeigt eine sechste Ausführungsform einer Schleifleiste 35 mit einer Verschleißanzeigemarkierung 36, wobei die Verschleißanzeigemarkierung 36 derart angeordnet ist, dass bei Erreichen eines definierten Verschleißgrades der Schleifleiste 35 das Bild einer Oberseite 37 der Schleifleiste 35 dahingehend verändert ist, dass bei Erreichen einer Verschleißgrenze 38 ein definierter Verschleißgrad angezeigt ist.

**Fig. 9b** zeigt die Schleifleiste 35 nach Erreichen des definierten Verschleißgrades der Schleifleiste 35. Die Verschleißanzeigemarkierung 36 ist nunmehr von einer hier nicht gezeigten Bildverarbeitungsvorrichtung erfassbar, wodurch das Erreichen des definierten Verschleißgrades angezeigt ist.

**Fig. 10** zeigt eine siebte Ausführungsform einer Schleifleiste 39 mit einer Verschleißanzeigemarkierung 40, wobei die Verschleißanzeigemarkierung 40 dieser Ausführungsform durch Ausnehmungen 41 in einem Material 42 der Schleifleiste 39 gebildet ist. Die Ausnehmungen 41 sind dabei derart ausgebildet, dass sie bei Erreichen eines definierten Verschleißgrades 43 der Schleifleiste 39 freigelegt werden, wobei dies ein von einer Bildverarbeitungsvorrichtung erfassbares Bild einer Oberseite 44 der Schleifleiste 39 dahingehend verändert, dass ein Verschleiß der Schleifleiste 39 angezeigt wird.

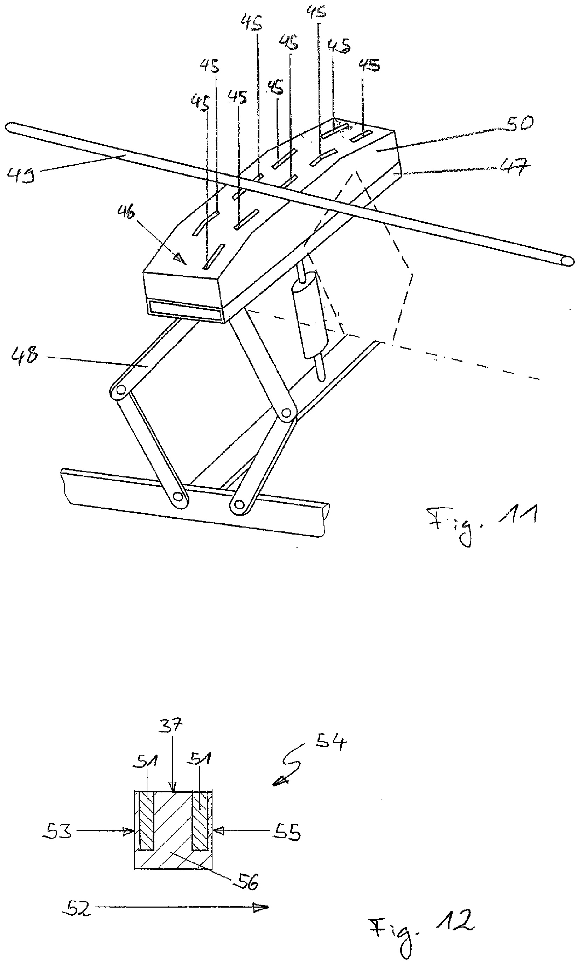

**Fig. 11** zeigt eine achte Ausführungsform einer Schleifleiste 50 mit Verschleißanzeigemarkierungen 45, welche gleichmäßig über eine Fläche 46 der Schleifleiste 50 verteilt sind. In der **Fig. 11** ist die Schleifleiste 50 auf einem Schleifleistenträger 47 dargestellt, welcher seinerseits auf einem Pantograph 48 angebracht ist, welcher die Schleifleiste 50 anzuheben und abzusenken vermag. Die Schleifleiste 50 liegt an einem Fahrdraht 49 an, wodurch eine elektrisch leitende Verbindung zwischen der Schleifleiste 50 und dem Pantograph 48 hergestellt ist.

**Fig. 12** zeigt eine neunte Ausführungsform einer Schleifleiste 54 mit Verschleißanzeigemarkierungen 51, welche in einem einer Fahrtrichtung 52 zugewandten Randbereich 53 der Schleifleiste 54 sowie einem der Fahrtrichtung abgewandten Randbereich 55 der Schleifleiste 54 angeordnet sind. Zudem sind die Verschleißanzeigemarkierungen 51 an einer Oberseite 57 der Schleifleiste 54 derart innerhalb dieser angeordnet, dass zu Beginn der Lebensdauer der Schleifleiste 54 die Verschleißanzeigemarkierungen 51 bereits von einer hier nicht dargestellten Bildverarbeitungsvorrichtung erfasst werden können, wobei bei Erreichen eines definierten Verschleißgrades die Verschleißanzeigemarkierungen 51 vollständig konsumiert sind, wodurch sich ein von der Bildverarbeitungsvorrichtung erfassbares Bild der Schleifleiste 54 verändert, was ein Überschreiten eines definierten Verschleißgrades anzeigt. Wird die Schleifleiste 54 während ihrer Lebensdauer derart beschädigt, dass Stücke des Schleifleistenmaterials 56 in einem der Randbereiche 53, 55 der Schleifleiste 54 herausbrechen, so ist ein von der Bildverarbeitungsvorrichtung erfassbares Bild der Schleifleiste 54 und der Verschleißanzeigemarkierungen 51 derart verändert, dass eine Beschädigung der Schleifleiste 54 angezeigt ist.

## Patentansprüche

1. Verschleißerkennungssystem mit einer Bildverarbeitungsvorrichtung und einer Schleifleiste (24) für eine fahrdrahtgebundene Stromversorgung von Fahrzeugen, wobei die Bildverarbeitungsvorrichtung eine Infrarotkamera ist,
**dadurch gekennzeichnet,**
**dass** die Schleifleiste zumindest eine Verschleißanzeigemarkierung (25) aufweist, welche derart ausgebildet ist, dass sie mittels der Bildverarbeitungsvorrichtung erfassbar ist, wobei die Bildverarbeitungsvorrichtung zur Erfassung der Verschleißanzeigemarkierung ausgebildet ist, wobei die Verschleißanzeigemarkierung (25) derart ausgebildet ist, dass sich das von der Bildverarbeitungsvorrichtung erfassbare Bild der Verschleißanzeigemarkierung bei zunehmendem Verschleiß kontinuierlich verändert.

2. Verschleißerkennungssystem nach Anspruch 1,
**dadurch gekennzeichnet,**
**dass** mittels einer oder mehrerer Verschleißanzeigemarkierungen (25) ein Verschleißgrad ermittelbar ist.

3. Verschleißerkennungssystem nach Anspruch 1 oder 2,
**dadurch gekennzeichnet,**
**dass** die Schleifleiste (24) derart ausgebildet ist, dass bei Überschreitung eines definierten Verschleißgrades der Schleifleiste ein von der Bildverarbeitungsvorrichtung erfassbares Bild der Schleifleiste gegenüber einem Bild der Schleifleiste vor Überschreitung des definierten Verschleißgrades verändert ist.

4. Verschleißerkennungssystem nach einem der vorangehenden Ansprüche,
**dadurch gekennzeichnet,**
**dass** die Verschleißanzeigemarkierung (25) in ein Material (26) der Schleifleiste (24) eingebettet ist.

5. Verschleißerkennungssystem nach einem der vorangehenden Ansprüche,
**dadurch gekennzeichnet,**
**dass** die Verschleißanzeigemarkierung (25) einen optischen Kontrast zu einem Material (26) der Schleifleiste (24) bildet.

6. Verschleißerkennungssystem nach einem der vorangehenden Ansprüche,
**dadurch gekennzeichnet,**
**dass** die Verschleißanzeigemarkierung (25) aus Kunststoff ausgebildet ist.

7. Verschleißerkennungssystem nach einem der vorangehenden Ansprüche,
**dadurch gekennzeichnet,**
**dass** die Verschleißanzeigemarkierung (25) in einem einer Fahrtrichtung zugewandten Randbereich der Schleifleiste (24) oder einem der Fahrtrichtung abgewandten Randbereich der Schleifleiste derart angeordnet ist, dass eventuelle Beschädigungen oder Abbrüche eines Materials (26) der Schleifleiste in diesem Randbereich mittels der Bildverarbeitungsvorrichtung erfassbar sind.

8. Verfahren zur Verschleißüberwachung einer Schleifleiste für eine fahrdrahtgebundene Stromversorgung von Fahrzeugen mit einem Verschleißerkennungssystem, wobei das Verschleißerkennungssystem eine Bildverarbeitungsvorrichtung und eine Schleifleiste (24) aufweist, wobei die Bildverarbeitungsvorrichtung eine Infrarotkamera ist,
**dadurch gekennzeichnet,**
**dass** die Schleifleiste eine Verschleißanzeigemarkierung (25) aufweist, wobei die Verschleißanzeigemarkierung mittels der Bildverarbeitungsvorrichtung erfasst wird, wobei die Bildverarbeitungsvorrichtung die Verschleißanzeigemarkierung erfasst, wobei die Verschleißanzeigemarkierung (25) derart ausgebildet ist, dass das von der Bildverarbeitungsvorrichtung erfassbare Bild der Verschleißanzeigemarkierung bei zunehmendem Verschleiß kontinuierlich verändert wird.

9. Verfahren nach Anspruch 8,
**dadurch gekennzeichnet,**
**dass** bei einem Verschleiß der Schleifleiste (24) zumindest eine in die Schleifleiste integrierte Verschleißanzeigemarkierung (25) und damit ein Bild oder eine Gestalt der Schleifleiste verändert wird, und dass diese Veränderung durch die Bildverarbeitungsvorrichtung erfasst und ausgewertet wird, und dass dadurch ein Verschleißgrad der Schleifleite bestimmt wird.

## Claims

1. A wear detection system, having an image processing device and a contact strip (24) for a current supply to vehicles based on contact wires, said image processing device being an infrared camera,
**characterised in that**
said contact strip features at least one wear indicator marking (25), which is designed in such a manner that it can be captured by means of the image processing device, said image processing device being designed for capturing said wear indicator marking, said wear indicator marking (25) being designed in such a manner that the image of the wear indicator marking that can be captured by the image processing device continuously changes as wear increases.

2. The wear detection system according to claim 1,
**characterised in that**
a degree of wear can be determined by means of one or more wear indicator markings (25).

3. The wear detection system according to claim 1 or 2,
**characterised in that**
the contact strip (24) is designed in such a manner that, when a defined degree of wear of the contact strip is exceeded, an image of the contact strip that can be captured by the image processing device is different from an image of the contact strip before the defined degree of wear was exceeded.

4. The wear detection system according to any one of the preceding claims,
**characterised in that**
the wear indicator marking (25) is embedded into a material (26) of the contact strip (24).

5. The wear detection system according to any one of the preceding claims,
**characterised in that**
the wear indicator marking (25) forms an optical contrast to a material (26) of the contact strip (24).

6. The wear detection system according to any one of the preceding claims,
**characterised in that**
the wear indicator marking (25) is formed from plastic.

7. The wear detection system according to any one of the preceding claims,
**characterised in that**
the wear indicator marking (25) is arranged in an edge region of the contact strip (24) facing in a direction of travel or in an edge region of the contact strip facing away from the direction of travel, in such a manner that any damage or ruptures of a material (26) of the contact strip can be captured in said edge region by means of the image processing device.

8. A method for monitoring, with the help of a wear detection system, the wear of a contact strip for a current supply to vehicles based on contact wires, wherein the wear detection system features an image processing device and a contact strip (24), wherein said image processing device is an infrared camera,
**characterised in that**
the contact strip features a wear indicator marking (25), wherein the wear indicator marking is captured by means of the image processing device, said image processing device capturing the wear indicator marking, said wear indicator marking (25) being designed in such a manner that the image of the wear indicator marking that can be captured by the image processing device experiences a continuous change as wear increases.

9. The method according to claim 8,
**characterised in that**
upon wear of the contact strip (24), at least one wear indicator marking (25) that is integrated into the contact strip, and thus an image or a shape of the contact strip, experiences a change, and **in that** the image processing device captures and evaluates said change, and **in that** a degree of wear of the contact strip is determined thereby.

## Revendications

1. Système de détection d'usure, ayant un dispositif de traitement d'images et une bande de frottement (24) pour l'alimentation électrique par caténaire de véhicules, le dispositif de traitement d'images étant une caméra infrarouge,
**caractérisé en ce que**
la bande de frottement présente au moins un marquage indicateur d'usure (25) qui est conçu de façon à pouvoir être détecté moyennant le dispositif de traitement d'images, le dispositif de traitement d'images étant conçu pour détecter le marquage indicateur d'usure, le marquage indicateur d'usure (25) étant conçu de telle façon que l'image du marquage indicateur d'usure qui peut être détectée par le dispositif de traitement d'images change de façon continue lorsque l'usure croît.

2. Système de détection d'usure selon la revendication 1,
**caractérisé en ce qu'**
un degré d'usure peut être déterminé moyennant un ou plusieurs marquages indicateur d'usure (25).

3. Système de détection d'usure selon la revendication 1 ou 2,
**caractérisé en ce que**
la bande de frottement (24) est conçue de telle façon qu'une image de la bande de frottement qui peut être détectée par le dispositif de traitement d'images, en cas de dépassement d'un degré d'usure défini de la bande de frottement, est changée par rapport à une image de la bande de frottement avant le dépassement du degré d'usure défini.

4. Système de détection d'usure selon l'une quelconque des revendications précédentes,
**caractérisé en ce que**
le marquage indicateur d'usure (25) est encastré dans un matériau (26) de la bande de frottement (24).

5. Système de détection d'usure selon l'une quelconque des revendications précédentes,
**caractérisé en ce que**
le marquage indicateur d'usure (25) contraste optiquement avec un matériau (26) de la bande de frottement (24).

6. Système de détection d'usure selon l'une quelconque des revendications précédentes,
**caractérisé en ce que**
le marquage indicateur d'usure (25) est conçu en matière plastique.

7. Système de détection d'usure selon l'une quelconque des revendications précédentes,
**caractérisé en ce que**
le marquage indicateur d'usure (25) est disposé dans une région périphérique de la bande de frottement (24) faisant face à un sens de la marche ou dans une région périphérique de la bande de frottement faisant face au côté opposé au sens de la marche, de telle façon que des dégradations ou des démolitions éventuelles d'un matériau (26) de la bande de frottement dans cette région périphérique peuvent être détectées moyennant le dispositif de traitement d'images.

8. Procédé de surveillance, avec un système de détection d'usure, de l'usure d'une bande de frottement pour l'alimentation électrique par caténaire de véhicules, le système de détection d'usure présentant un dispositif de traitement d'images et une bande de frottement (24), le dispositif de traitement d'images étant une caméra infrarouge,
**caractérisé en ce que**
la bande de frottement présente un marquage indicateur d'usure (25), le marquage indicateur d'usure étant détecté moyennant le dispositif de traitement d'images, le dispositif de traitement d'images détectant le marquage indicateur d'usure, le marquage indicateur d'usure (25) étant conçu de telle façon que l'image du marquage indicateur d'usure qui peut être détectée par le dispositif de traitement d'images est changée de façon continue lorsque l'usure croît.

9. Procédé selon la revendication 8,
**caractérisé en ce qu'**
en cas d'usure de la bande de frottement (24), au moins un marquage indicateur d'usure (25) intégré dans la bande de frottement, et par voie de conséquence une image ou la forme de la bande de frottement, est changé, et **en ce que** ce changement est détecté et évalué par le dispositif de traitement d'images, et **en ce qu'**un degré d'usure de la bande de frottement est déterminé ainsi.
